# EUROPÄISCHE PATENTSCHRIFT

(11) **EP 0 334 204 B1**
(45) Veröffentlichungstag und Bekanntmachung des Hinweises auf die Patenterteilung: **19.04.1995**
(21) Anmeldenummer: 89104693.0
(22) Anmeldetag: 16.03.1989
(51) Int. Cl.: C23C 14/32, H01J 37/32

(54) **Verfahren und Anlage zur Beschichtung von Werkstücken**
Process and apparatus for coating articles
Procédé et dispositif de revêtement d'objets

(30) Priorität: 23.03.1988 CH 1095/88
(43) Veröffentlichungstag der Anmeldung: 27.09.1989
(73) Patentinhaber: BALZERS AKTIENGESELLSCHAFT, 9496 Balzers (LI)
(72) Erfinder: Buhl, Rainer, Dr., CH-7320 Sargans (CH)
(74) Vertreter: Troesch, Jacques J., Dr. sc. nat.

(56) Entgegenhaltungen:
- US-A- 4 452 686
- INSTR. AND. EXPERIMENT. TECH., Band 21, Nr. 6, Teil 2, November/Dezember 1978, Seiten 1650-1652, Plenum Publishing Corp.; V.A. OSIPOV et al.: "Unit for depositing coatings by precipitation of ions extracted from a vacuum-arcplasma"

## Beschreibung

Die vorliegende Erfindung betrifft eine Vakuumbeschichtungsanlage nach dem Oberbegriff von Anspruch 1.

Die vorliegende Erfindung liegt im Gebiet der Verdampfung elektrisch leitender Stoffe mittels Kathodenpunkten einer Bogenentladung.

Diese Art der Verdampfung eignet sich besonders gut zum plasmaunterstützten Beschichten, weil die Kathodenpunkte das Kathodenmaterial im wesentlichen nicht als neutralen Dampf emittieren wie andere für die Vakuumbeschichtung benutzte Quellen, sondern zum überwiegenden Teil bereits als Ionen. Die Ionen bilden zusammen mit den ebenfalls emittierten Elektronen ein Plasma hoher Dichte, welches eine Beschichtung mit hoher Geschwindigkeit erlaubt. Gleichzeitig sind durch die plasmaunterstützte Schichtbildung günstige Schichteigenschaften (hohe Dichte und Festigkeit, geringe Rauhigkeit) erreichbar, und zwar sowohl für Schichten, die durch Niederschlag des aus der Kathode erzeugten Metalldampfes allein gewonnen werden, wie auch insbesondere für Schichten aus Verbindungen des Metalles mit einem der Restgasatmosphäre im Aufdampfraum zugefügten reaktiven Gas. Mit der Anwendung plasmaunterstützter Vakuumbeschichtungsverfahren wurde die Palette der Verbindungen, welche reaktiv unter Zufuhr der konstituierenden Komponenten aus verschiedenen Quellen bei der Abscheidung auf einem Substrat erzeugt werden können, über die verbreitete Herstellung von Oxiden hinaus bedeutend erweitert.

In der vorliegenden Beschreibung werden Kathoden einer elektrischen Bogenentladung, an denen Kathodenmaterial infolge der Wärmeentwicklung des Bogens so stark erhitzt wird, dass es verdampft, als Verdampfungskathoden bezeichnet. Da die Verdampfung an der Kathodenfläche nur punktweise an den stochastisch hin und her wandernden Fusspunkten der Entladung erfolgt und diese den Eindruck von Funken erwecken, wird diese Verdampfungsmethode oft auch als Funkenverdampfung bezeichnet.

Bei der bekannten Funkenverdampfung von ebenen Verdampfungskathoden gehorcht die Richtungsverteilung der emittierten Ionen nahezu dem cos-Gesetz, d.h. die in einer Richtung, welche mit dem Lot auf die Kathodenfläche den Winkel α einschliesst, beobachtete Strömung des verdampften Materials ist um den Faktor cos α kleiner als die Emission in der Senkrechten. Es ist deshalb vom Gesichtspunkt einer rationellen Beschichtung her gesehen zweckmässig, die zu beschichtenden Substrate nahe bei dem dem Mittelpunkt der Verdampfungskathode zugeordneten Lot anzuordnen. Bei der Verdampfung aus Kathodenpunkten empfahl sich dies bisher auch deshalb, weil dabei Material von der Oberfläche der Kathode in erheblichem Masse auch in Form von kleinen flüssigen Tröpfchen mit einer von den Ionen abweichenden Richtungsverteilung emittiert wird, wobei die meisten, insbesondere die grösseren Tröpfchen die Kathode mit ausgeprägter Tangentialkomponente verlassen. Dies ist im Mechanismus der Bogenentladung, deren Fusspunkte ("Funken") auf der Kathodenoberfläche sich frei bewegen können, begründet. Da der Elementarvorgang eine Verdampfung aus lokal stark überhitzten Gebieten in der Nähe der Funken ist, existiert immer eine flüssige Phase, von welcher ein Teil unter dem Druck des gebildeten Dampfes als Tröpfchen weggeschleudert wird.

Die Tröpfchen können im Fluge oder beim Auftreffen auf die Substrate bzw. Werkstücke erstarren und verschiedene nachteilige Eigenschaften der erzeugten Schichten nach sich ziehen, wie z.B. erhöhte Rauhigkeit der Schichtoberfläche, Verunreinigung der Schicht, erhöhte Korrosionsanfälligkeit nach einem Ausbrechen der Spritzer u.a. Am wenigsten Spritzer findet man auf Werkstücken, die in der Nähe des Lotes angeordnet sind, also dort, wo gleichzeitig die Beschichtungsgeschwindigkeit am grössten ist.

Spezieller bezieht sich nun die vorliegende Erfindung auf das erwähnte "Spritzer"-Problem.

Bisher übliche Vorrichtungen für die Vakuumbeschichtung unter Anwendung des Verdampfens aus Kathodenpunkten versuchten die unterschiedliche Emissionscharakteristik von Dampf und Spritzer auszunutzen, um Schichten mit der kleinstmöglichen Zahl von Fehlern durch Spritzer zu erhalten. Die Substrate werden zu diesem Zweck nahe beieinander in einem (relativ zum Durchmesser der Kathode) kleinen Bereich bzw. Feld um die Kathodenachse herum und in möglichst grossem Abstand von der Kathode angeordnet. Der geforderte grosse Abstand der Kathode von den Werkstücken einerseits und die kleine Anzahl der nahe der Achse Platz findenden Werkstücke andererseits erlaubt jedoch keine wirtschaftliche Fertigung. Deshalb sind bisher bei der Anwendung der sogenannten Funkenverdampfung stets Kompromisse in Richtung zu kleinerem Abstand bzw. zu ausgedehnteren Feldern in Kauf genommen worden, was allerdings eine wesentliche Verschlechterung bezüglich Häufigkeit der Spritzer zur Folge hatte. Daher zielen bereits verschiedene bekannte Bestrebungen auf eine Verminderung der Spritzer.

Nebst anderen gibt es Vorschläge, die für die Beschichtung erwünschten Ionen des Kathodenmaterials von den unerwünschten Spritzern auf plasmaoptischem Wege zu trennen. Dem Prinzip nach geht es dabei stets darum, die Ionen in ein Gebiet zu lenken, welches keine direkte Sichtverbindung zur Kathode hat. Dort kann man dann auch die Werkstücke aufstellen, die von den Tröpfchen nicht erreicht werden können, weil ihr Masse/Ladungsverhältnis sich um Grössenordnungen von dem der einzelnen Ionen unterscheidet.

Eine Variante (z.B. DE-PS-32 34 100) sieht einen rotationssymmetrischen Werkstückhalter in der Achse eines Rezipienten vor, um den herum ein Verdampfer von grösserem Radius ringförmig angeordnet ist, aber mit seiner verdampfenden Fläche nicht auf die Substrate zu, sondern nach aussen weist. Die zylindrische Wand des Rezipienten wirkt hierbei als ein die Ionen spiegelndes Element.

Hier ist der Raum, der bei gegebener Anlagengrösse für das Anordnen gleichzeitig zu beschichtender Werkstücke zur Verfügung steht, auf den Axialraum des Rezipienten begrenzt.

Eine andere Variante (z.B. US-PS-4 452 686, Fig. 2) nutzt allein die längs der Achse eines rotationssymmetrischen Rezipienten emittierten Ionen aus und führt sie ebenfalls mittels einer Spiegelung an der Rezipientenwand um ein die Spritzer abfangendes Hindernis auf die im spritzerfreien Raum montierten Werkstücke.

Der hier für das Anordnen gleichzeitig zu beschichtender Werkstücke zur Verfügung stehende Raum ist grundsätzlich durch die Querschnittsfläche der Rezipientenwand gegeben, wobei aber die die Spritzer abfangenden Hindernisse dazu neigen, bezüglich des Ionenbefalls auf Werkstücke Schatten zu werfen, womit mindestens im Bereiche dieser Hindernisse nicht die gesamte Querschnittsfläche des Rezipienten gleichermassen für das Anordnen zu beschichtender Werkstücke geeignet ist.

Aus dem Artikel "Transport of plasma streams in a curvilinear plasma-optics system" von I.I. Aksenov et al. aus Soviet Journal Plasma Physics 4(4), July-August 1978, ist es bekannt, die abgedampften Ionen durch ein Umlenkrohr auf ein Werkstück umzulenken, womit wiederum eine direkte Sichtverbindung zwischen Werkstück und Kathode verhindert wird. Das Werkstück wird dabei im wesentlichen an der Ausmündung des Umlenkrohres angeordnet, die Sichtverbindung durch die Krümmung des Rohres unterbunden. Der hier ausgenützte Raum zum Beschicken der Anlage mit gleichzeitig zu beschichtenden Werkstücken ist ebenfalls relativ gering.

Es wird noch auf die nachfolgenden Schriften zum Stande der Technik verwiesen:
- DE-PS-32 34 100
- CH-PS-655 632
- CH-PS-656 400
- CH-PS-657 242
- US-PS-4 191 888
- US-PS-4 452 686
- US-PS-4 492 845
- EP-A-0 094 473
- EP-A1-0 286 191
- GB-A-2 117 610
- SE-B-430 293
- Patent Abstracts of Japan, vol. 10, no. 170 (E-412) [2226], 17. Juni 1986; & JP-A-61 22 548 (Hitachi Seisakusho K.K.) 31.1.1986
- Nuclear Instruments and Methods, vol. 185, nos. 1-3, Juni 1981, S. 25-27, North-Holland Publ. Co., Amsterdam/NL; J.H. Whealton: "Improvement of gas efficiency of negative ion sources"
- Patent Abstracts of Japan, vol. 6, no. 72 (E-105)[950], 7. Mai 1982; & JP-A-57 11 447 (Tokyo Shibaura Denki K.K.) 21.1.1982
- Patent Abstracts of Japan, vol. 4, no. 170 (E-35)[652], 22. November 1980; & JP-A-55 117 856 (Hitachi Seisakusho K.K.) 10.9.1980
Aus "Instr. and Experiment. Tech.", Band 21, No. 6, Teil 2, November/Dezember (1978), pp. 1650-1652 (V.A. Osipov et al.), ist eine Anlage der eingangs genannten Art bekannt. Zu beschichtende Werkstücke sind auf einer Ebene angeordnet, die die Verdampfungsfläche der Kathode allseitig radial umgibt und im wesentlichen auf derselben Höhe liegt. Den Werkstücken gegenüberliegend wird mittels magnetischer Felder eine Potentialbarriere aufgebaut, woran Ionen, die von der Verdampfungsfläche austreten, gegen die Werkstücke zurückreflektiert werden. Damit erfahren diese Ionen eine Umlenkung von genähert 180°, indem sie im wesentlichen auf diejenige Ebene zurückgeworfen werden, aus der sie auch durch Verdampfen ausgetreten sind.

Die vorliegende Erfindung setzt sich zum Ziel, eine Anordnung letztgenannter Art so weiterzubilden, dass der zum Einbringen gleichzeitig spritzerfrei zu beschichtender Werkstücke zur Verfügung stehende Raum und somit die Produktivität einer solchen Anlage gesteigert werden.

Grundsätzlich wird dabei die ohnehin zu erreichende Unterbindung der direkten Sichtverbindung zwischen Werkstück und Kathode gerade dazu ausgenützt, den zur Verfügung stehenden Beschickungsraum für Werkstücke zu vergrössern, was dadurch erreicht wird, dass die von der Kathode abgedampften Ionen aus einem axial engen Raum um eine ringförmige Sichtblende herum radial nach aussen umgelenkt werden, derart, dass die Werkstücke peripher aussenliegend angeordnet werden können, somit eigentlich ein Ringraum für die Werkstücke gebildet werden kann, der wegen des nach aussen zunehmenden Radius wesentlich grösser sein kann als der für die Umlenkung und Erzeugung der Ionen notwendige Raum.

Bezeichnet man die Anordnung als Rezipienten um eine Achse, die die Kathode durchdringt, vorzugsweise aber nicht zwingend senkrecht, so wird bei diesem Vorgehen der für Aufstellung der Werkstücke wie der Substrate nutzbare Durchmesser eines solchen Rezipienten nicht durch Umlenkmittel, wie Reflektoren, gegeben, sondern weitgehend durch den Aussendurchmesser des für die Aufnahme von Werkstücken zur Verfügung stehenden Raumes.

Um die Umlenkung der abgedampften Ionen radial nach aussen in einfacher Art und Weise zu realisieren, wird der Kathode eine Ringanode gemäss Wortlaut von Anspruch 2 zugeordnet, durch deren Innenöffnung die Ionen geführt werden und mithin radial nach aussen umgelenkt werden.

Es wird erreicht, dass möglichst wenig Ionen in Axialrichtung fortschreiten und nicht radial nach aussen umgelenkt werden.

Dabei wird direkt das der Kathode abgelegene Ende des Führungskanals als Sichtbereichsbegrenzung zwischen Kathode und den Werkstücken vorgesehen. Der Führungskanal wirkt wie ein über die Kathode gelegtes Rohr, womit den Werkstücken, radial ausserhalb angeordnet und in einem solchen radialen Abstand, dass die Oberkante des Rohres als Sichtbereichsbegrenzung wirkt, der Blick auf den Grund des Rohres und somit auf die Kathode verwehrt ist.

Im weiteren wird eine Anordnung gemäss Wortlaut von Anspruch 3 vorgeschlagen, womit wegen des anodischen Potentials, auf das auch der Kragen gelegt ist, und der radialen Komponente eines vorgesehenen Magnetfeldes eine radial die Ionen umlenkende Wirkung erzielt wird.

Durch Ausbildung nach dem Wortlaut von Anspruch 4 wird, in Axialrichtung betrachtet, eine gestaffelt sich öffnende Führungsstruktur geschaffen, und die Ionen werden über einen relativ ausgedehnten radialen Bereich mehr und mehr umgelenkt.

Grundsätzlich wird dies auch gemäss Wortlaut von Anspruch 5 erreicht, durch eine Struktur, die auch durch die oben erwähnte Ringanode und den erwähnten Kragen realisiert ist.

Wesentlich wird die Umlenkung durch Vorsehen des Magnetfeldes unterstützt.

Die gesamte, bis anhin beschriebene Anlage mit ihrem Grundaufbau nach Anspruch 1 und den weiter beschriebenen Merkmalen wird vorzugsweise nach dem Wortlaut von Anspruch 7 doppelt aufgebaut, so dass zwei Kathoden koaxial angeordnet gleichermassen in denselben Raum für die Werkstücke wirken. Anstelle der erwähnten Ringanode bzw. der erwähnten ringförmigen, auf anodischem Potential betriebenen Elektroden kann und wird vorzugsweise die Wandung eines Rezipienten für die Werkstükke, d.h. die Innenwand radial hinter dem Raum für die Werkstücke, anodisch betrieben.

Auch wenn die Anordnung einfach aufgebaut ist, also nicht, wie im erwähnten Anspruch 7 spezifiziert, spiegelbildlich doppelt und in denselben Raum für die Werkstücke wirkend, wird bevorzugterweise und gemäss Wortlaut von Anspruch 10 das Magnetfeld so aufgebaut, dass es spiegelbildlich verläuft.

Dies unabhängig davon, ob nun auch die Kathodenanordnung, wie erwähnt, Spiegelbildlich doppelt vorgesehen ist.

Dem Wortlaut von Anspruch 11 folgend kann es dabei in gewissen Anwendungsfällen vorteilhaft sein, die Magnetanordnung zur Erzeugung des erwähnten Magnetfeldes ansteuerbar auszubilden, um das Magnetfeld in der Zeit zu modulieren, beispielsweise um die Beschichtung auf den Werkstücken gezielt zu beeinflussen, wie zu homogenisieren, und/oder um den Abtrag kathodenseitig gezielt zu beeinflussen.

Beim Einsatz eines spiegelbildlichen Magnetfeldes wird gemäss Anspruch 12 die erwähnte Modulation der beiden spiegelbildlichen Anteile grundsätzlich unabhängig voneinander ansteuerbar ausgebildet, womit die Ansteuerung einer gewünschten Abhängigkeit, beispielsweise einer vorgegebenen Phasenverschiebung der Modulation beider spiegelbildlichen Anteile realisierbar ist. Beispielsweise kann das Magnetfeld amplitudenmoduliert werden.

Obwohl es durchaus möglich ist, die erwähnten Magnetfelder mit Permanentmagneten zu erzeugen, im Falle einer Modulierbarkeit, letztere beispielsweise durch mechanische Beweglichkeit der Permanentmagnete zu erzielen, wird vorgezogen, mindestens Teile des erwähnten Magnetfeldes gemäss Wortlaut von Anspruch 13 durch eine koaxiale Spulenanordnung zu erzeugen, d.h. elektromagnetisch.

Die Erfindung wird anschliessend an einem Ausführungsbeispiel anhand der anliegenden Zeichnung noch näher erläutert.

Die Zeichnung zeigt die Beschichtungskammer 1, die über den Stutzen 2 evakuierbar ist und in der mehrere drehbare Halterungen 4 in einem Ringraum 4' angeordnet sind für zu beschichtende Substrate als Werkstücke, die mittels durch die Kammerwand vakuumdicht hindurchgeführter Wellen 3 angetrieben werden. Der Einfachheit halber ist nur eine solche Halterung gezeichnet, doch können, etwa auf einem Kreis rund um die Achse A der Beschichtungskammer herum, eine Mehrzahl Halterungen gleicher oder ähnlicher Art Platz finden, womit, wegen des grossen ausnützbaren Ringraumdurchmessers D₄, viele Werkstücke gleichzeitig bearbeitet werden können.

Wie ersichtlich, ist die Kammer 1 durch am Boden 5 und an der Decke 6 derselben angeflanschte Zylinder 7 bzw. 7' erweitert, in denen die Kathoden 8 bzw. 8' zur Funkenverdampfung angeordnet sind. Die Kathoden sind von einer gekühlten Haltevorrichtung 9 bzw. 9' getragen, wobei die Kühlmittelzu- und -ableitungen 10 und 11 bzw. 10' und 11' elektrisch isoliert durch die Wand der Vakuumkammer hindurchgeführt sind. Jeder der beiden Kathoden ist eine ringförmige Anode 12 bzw. 12' zugeordnet, die der isolierte Stromdurchführungen 13 bzw. 13' und Leitung 14 bzw. 14' mit dem positiven Pol der Spannungsquellen 15 bzw. 15' verbunden sind. Der negative Pol dieser Spannungsquellen steht über die Leitungen 16 bzw. 16' und die Kühlmittelleitungen 11 bzw. 11' mit den Kathodenhaltern 9 bzw. 9' in Verbindung.

Die Entladungskanäle sind von je einem Hilfselektrodenmantel umgeben. Im Ausführungsbeispiel werden diese durch eingesetzte metallische Zylinder 20 und 20' und mit diesen verbundene Ringkragen 21 und 21' gebildet. Sie sind über Spannungsdurchführungen 32, 32' mit der positiven Seite der Spannungsquellen 29, 29' verbunden, und da letztere mit den Spannungsquellen 15, 15' wie ersichtlich in Reihe geschaltet sind, liegen die Kragen 21, 21' und die Zylinder 20, 20' gegenüber der Kathode auf einem Potential, das der Summe der Spannungen der beiden hintereinandergeschalteten Spannungsquellen entspricht; zweckmässigerweise werden diese einstellbar gemacht, so dass die für die Umlenkung der Ionen erforderlichen Potentiale dem jeweiligen Anwendungsfall entsprechend optimal gewählt werden können.

Es müssen nicht unbedingt die dargestellten ringförmigen Kragen 21, 21' um die zylindrischen Teile 20, 20' vorgesehen sein; es genügt in vielen Fällen, entweder die einen Teile oder die anderen vorzusehen.

Die vorgesehenen, auf anodischem Potential allenfalls gestaffelt gelegten Ringelektroden beeinflussen wesentlich die Umlenkbahn der Ionen radial nach aussen, und es wird die Anzahl derartiger Ringelektroden, deren Zentrumsöffnung und deren Potential nach erwünschter Umlenkung gewählt, wonach sich auch die Plazierung der Halter für die Werkstücke richtet.

Bevorzugterweise wird auch zusätzlich oder anstelle der Ringanoden 12 und 12' entlang der Wandung 5a, wie bei 5b gestrichelt dargestellt, ein anodisch betriebener Mantel vorgesehen. Selbstverständlich wird dieser anodisch betriebene Mantel 5b bezüglich der Wandung der Kammer 5a isoliert und der Stutzen 2 isoliert durch diese Anode 5b durchgeführt.

Wenn die zylindermantelförmigen Teile der Hilfselektrode 20, 20', wie oben als Möglichkeit erwähnt, weggelassen werden, können die Wände der zylinderförmigen Ausbuchtungen 7, 7' der Vakuumkammer selbst als Sichtabschirmungen dienen, um eine Sichtverbindung zwischen den Kathoden und den Werkstücken zu vermeiden. Am wichtigsten für die Umlenkwirkung der Hilfselektroden auf die Ionen ist der Bereich an der den Substraten zugewandten Kante der Zylinder 20, 20' bzw. die Innenkante der Ringscheibe 21, 21'.

Die Zylinder 7, 7' sind je, wie dargestellt, durch drei Magnetspulen 22, 23, 24 bzw. 22', 23' und 24' umgeben, welche je ein im Innenraum der Zylinder 7 bzw. 7' im wesentlichen achsparalleles Feld erzeugen, wobei die erwähnten Spulen so gepolt betrieben werden, dass das Magnetfeld B, B' in der in der Figur eingetragenen jeweiligen Richtung entsteht. Dieses Magnetfeld wirkt in bekannter Weise auf die geladenen Partikel ein. Das bedeutet, dass die Elektronen innerhalb der Zylinder 7, 7' bzw. der eingesetzten, als Hilfselektroden wirkenden Zylinder 20, 20' sozusagen um die Magnetfeldlinien herum gewunden spiralförmige Bahnen beschreiben und entlang dieser Feldlinien driften, bis sie in den Hauptraum 4' der Kammer austreten und von den Anoden bzw. den anodisch betriebenen Teilen angezogen werden.

Dank der Führung durch das Magnetfeld können die Elektronen nur in relativ geringem Masse die Wandung des Hilfselektrodenzylinders 20, 20' erreichen. Die positiv geladenen Ionen hingegen werden vom anodischen Potential des Hilfselektrodenzylinders 20, 20', dessen Kragen 21, 21' sowie der Anode 12, 12' abgestossen und beschreiben um diese herum gekrümmte Bahnen, derart, dass sie auf die Werkstücke, beispielsweise Substrate, hin abgelenkt werden. Zwei dieser Bahnen sind in der Zeichnung beispielsweise strichpunktiert eingetragen.

Die Spulen 22 und 22' bauen den Hauptteil des homogenen Magnetfeldes für die Plasmaführung auf, während die kürzeren Spulen 23, 23' die Endanpassung besorgen, womit dieses auf verschieden grosse Kathodenflächen und Durchmesser der als Reflektoren wirksamen rohrförmigen Hilfselektroden optimiert werden kann. Bei der Gestaltung des Magnetfeldes soll darauf geachtet werden, dass möglichst keine Feldlinien von den zu verdampfenden Kathodenflächen zur Hilfselektrode führen, allerdings sollen die den Rand der Kathodenflächen durchstossenden magnetischen Feldlinien auch nicht in zu grossem Abstand von den Innenwänden der Hilfselektroden verlaufen, damit die emittierten Ionen optimal genutzt werden können. Die Spulen 24, 24' verstärken das magnetische Feld für den Eintritt der Ionen in den Hauptraum der Beschichtungskammer und sorgen auch dafür, dass möglichst wenig Elektronen die Hilfselektrode 20, 20' - im Bereich ihrer Oeffnungen in den Raum 4' - erreichen, denn die auf diese Weise verlorenen Elektronen würden die Plasmadichte in der Beschichtungskammer und damit den für die Beschichtung nutzbaren Ionenstrom vermindern und die benötigte elektrische Leistung erhöhen. Durch das von den Spulen 24, 24' erzeugte Zusatzfeld wird bewirkt, dass die Magnetfeldsäule, ausgehend von der Kathode, praktisch vollständig in die Beschichtungszone übergeht, ohne auf die Hilfselektroden überzugehen. Um diese Wirkung noch zu unterstützen, können die genannten Spulen mit einer Ummantelung 31 aus magnetisch weichem Eisen versehen werden.

Bei passender Abstimmung dieses achsparallelen Magnetfeldes B, B' und den Betriebsspannungen kann die Elektrode aus Zylinder 20, 20', allenfalls Kragen 21, 21', auf einen im Stossbereich dieser Kragen 21, 21' mit der Wandung der Zylinder 20, 20' vorgesehenen Ringelektrodendraht beschränkt werden.

Beim Beschichtungsbetrieb findet die die Verdampfung der Kathoden bewirkende Bogenentladung zwischen der jeweiligen Verdampfungskathode und der zugehörigen Anode statt. Die Dimensionen der Ringelektroden, d.h. hier der zylindrischen Teile 20 bzw. 20', und der Durchmesser des Kreises, auf dem die Werkstücke tragenden Haltevorrichtungen 4 angeordnet sind, müssen, wie gesagt, so bemessen sein, dass die Werkstücke von keinem Punkt der Kathode aus gesehen werden können. Die für den Raum, in den von der Kathode ausgeschleuderte Tröpfchen hingelangen können, massgebenden Oeffnungswinkel sind in der Zeichnung in punktierten Linien eingetragen. Die Substrate bzw. Werkstücke auf den Werkstückhaltern müssen also ausserhalb dieses Raumes angeordnet sein, damit sie nicht von Tröpfchen des Targetmaterials getroffen werden können.

Gegenüber bekannten Anordnungen erreicht man in einer erfindungsgemässen Beschichtungsanlage eine wesentlich bessere Ausbeute an für die Beschichtung verwertbaren Ionen. Beispielsweise konnte mit der beschriebenen Anordnung bei einem Bogenstrom von 400A pro Kathode, einer Bogenspannung von 28V und einem Potential der als Ionenreflektoren wirksamen Hilfselektroden von +36V sowie einem Potential der Substrate von -30V (beide gegenüber den Verdampfungskathoden gemessen) mit einem Magnetfeld von 98 Oe in der Achse der beiden Zylinder 20, 20', ein Ionenstrom zu den Substraten auf einem der Substrathalter 4 von insgesamt 1,9A gemessen werden. Dabei wurden vollkommen spritzerfreie Schichten erzielt, d.h. die Abtrennung der Ionen von den von den Kathoden gleichzeitig ausgeschleuderten Tröpfchen gelang einwandfrei.

Die erfindungsgemässe Kathodenverdampfungsmethode lässt sich nicht nur für die Verdampfung von Metallen anwenden, sondern auch zur Verdampfung nichtmetallischer Stoffe, sofern diese eine hinreichende elektrische Leitfähigkeit aufweisen.

Das beschriebene Ausführungsbeispiel zeigt zwar in einer Vakuumkammer zwei Kathodenverdampfer, aber selbstverständlich ist es auch möglich, eine Anlage mit nur einer oder mit mehreren Verdampfungskathoden zu bauen oder beispielsweise bei der beschriebenen Anlage nur die untere etwa für die Verdampfung eines ersten Materials und zu anderer Zeit die obere Verdampfungskathode für die Verdampfung eines zweiten Materials zu benutzen.

In weiterer Ausgestaltung der Erfindung lässt sich die gleiche Anordnung, die zum Beschichten verwendet wird, auch als vor der Beschichtung oder zwischendurch zu gebrauchende Einrichtung zum Aetzen der Substrate durch Kathodenzerstäubung nutzen. Dazu ist es zweckmässig, ausser den Kathoden für die Verdampfung noch eine weitere als Glühkathode 26 ausgebildete Kathode für eine Niedervolt-Bogenentladung vorzusehen, wobei diese Glühkathode am besten in einer mit der Beschichtungskammer über eine Oeffnung 27 in einer Trennwand in Verbindung stehenden Nebenkammer 25 untergebracht wird. Die Trennwand kann auf der der Beschichtungskammer zugewandten Seite als Kathodenfläche für die Verdampfung ausgebildet werden.

Mit einer solchen zusätzlichen Glühkathode und einer Anode 12, 12' wird in der Beschichtungskammer ein Niedervoltbogen betrieben - gezündet z.B. durch Kurzschluss zwischen Kammer 25 und Anode 12 -, und wenn die Entladung in einer edelgashaltigen Restgasatmosphäre, z.B. Argon, erfolgt, das vorzugsweise über die Nebenkammer 25 zugespiesen wird, bewirken die auf das Substrat auftreffenden Edelgasionen eine Abstäubung von der Substratoberfläche und damit in an sich bekannter Weise eine laufende Reinigung derselben, wodurch oft eine bessere Haftfestigkeit der durch Ionendeposition aufzubringenden Schichten erreicht wird. Dazu ist noch zu bemerken, dass schon beim Verfahren der Ionendeposition gleichzeitig stets auch eine Zerstäubung stattfindet, wobei aber die Depositionsgeschwindigkeit und damit der Schichtaufbau die Zerstäubungsgeschwindigkeit bzw. den damit verbundenen Schichtabbau überwiegen. Man kann das Verhältnis von Schichtdeposition zur Schichtzerstäubung u.a. durch den Partialdruck des der Restgasatmosphäre beigefügten Edelgases oder auch durch die Vorspannung der Substrate beeinflussen.

Wie aus der dargestellten Figur ohne weiteres und prinzipiell ersichtlich, wird dadurch, dass die Ionen radial und nach allen Seiten nach aussen umgelenkt werden, grundsätzlich der zum Vorsehen zu beschichtender Werkstücke zur Verfügung stehende Raum 4' gegenüber bekannten Anordnungen vergrössert, womit nach dem erfindungsgemässen Verfahren arbeitende erfindungsgemässe Anlagen eine erhöhte Wirtschaftlichkeit ergeben.

In der Figur ist eine bevorzugte Ausführungsvariante dargestellt, bei der die Anordnung aus im wesentlichen identischen spiegelbildlich zu einer Ebene E durch den Hauptraum 4' für die Werkstücke aufgebauten Teilanordnungen zusammengesetzt ist. Die erfindungsgemässe Anordnung kann aber auch nur aus einer dieser Teilanordnungen, beispielsweise gemäss der Figur dem oberen Teil, bestehen. Auch in diesem Fall wird aber vorzugsweise das gesamte in der Figur dargestellte Magnetfeld B, B' aufgebaut, d.h. auch dann der in diesem Fall einzigen Kathode axial gegenüberliegend, bezüglich der Ebene E, eine Magnetanordnung vorgesehen, die das spiegelbildliche Magnetfeld B' erzeugt.

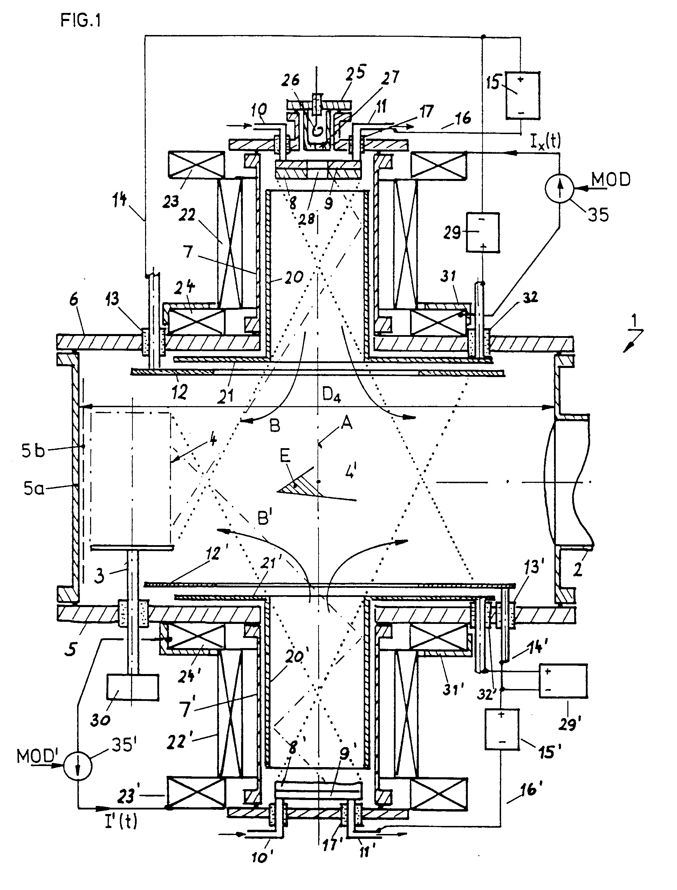

Wird somit beispielsweise die Anordnung lediglich aus der in Fig. 1 dargestellten oberen Anordnungshälfte aufgebaut, mit welcher das Magnetfeld B erzeugt wird, so wird vorzugsweise auch in diesem Fall eine Magnetanordnung, wie mit einer oder mehreren der Spulen 22', 23', 24', vorgesehen und somit auch der Magnetfeldanteil B' erzeugt.

Die Magnetfelder B, B' können, wie dargestellt, elektromagnetisch erzeugt werden, können aber auch ohne weiteres permanentmagnetisch erzeugt werden oder mindestens teilweise. Um den Auftrag auf den Werkstücken örtlich und zeitlich gezielt zu beeinflussen, können im weiteren die Magnetfelder B bzw. B' in der Zeit moduliert werden, beispielsweise amplitudenmoduliert werden, wozu an dem in Fig. 1 dargestellten Beispiel mindestens ein Teil der Spulenanordnung 22, 22' bis 24, 24' mit einem in der Zeit modulierten Strom beaufschlagt wird, beispielsweise zur Erzeugung eines amplitudenmodulierten Feldes B bzw. B'. Dabei wird bei Doppelaufbau der Anordnung, wie in der Figur dargestellt, bevorzugterweise jede der spiegelbildlich vorgesehenen Spulenanordnungen unabhängig ansteuerbar ausgebildet und die gegenseitige Abhängigkeit, beispielsweise Phasenverschiebung der Modulationen, gezielt eingesetzt. Durch Modulation des Magnetfeldes wird, wie erwähnt, der Auftrag in der Zeit an den Werkstücken gezielt beeinflusst und/oder der zeitlich-örtliche Abtrag an der einen oder den beiden vorgesehenen Kathoden 8, 8'.

In der Figur ist die erwähnte Modulationsmöglichkeit schematisch mit den die Spulenanordnungen speisenden Stromquellen 35, 35' angedeutet, welche je an Modulationseingängen MOD bzw. MOD' modulierbar sind.

## Patentansprüche

1. Vakuumbeschichtungsanlage zur Beschichtung von Werkstücken mit mindestens einer in einer evakuierbaren Kammer (1) angeordneten Verdampfungskathode (8, 8'), wobei die Kammer (1) einen Beschichtungsraum (4') mit einer ringförmigen Wandung (5a) aufweist, mindestens einer Anode (12, 12'), radial im Beschichtungsraum (4') angeordneten Halterungen (4) für Werkstücke, die einer direkten Sichtverbindung zur Kathode (8, 8') entzogen sind, Ablenkmitteln (5b, 12, 12', 22, 22', 23, 23', 24, 24', 20, 20'), um von der Kathode (8, 8') abgedampfte Ionen allseitig radial nach aussen umzulenken, dadurch gekennzeichnet, dass
- die Kathode (8, 8'),
- ein zylindrischer Führungskanal (20, 20') für von der Kathode (8, 8') abgedampfte Partikel, der im Betrieb der Anlage bezüglich der Kathode (8, 8') auf positives Potential gelegt ist, und
- der Beschichtungsraum (4')
entlang einer die Kathode (8, 8') vorzugsweise senkrecht durchdringenden Achse (A) hintereinander gestaffelt und koaxial angeordnet sind, derart, dass die Verdampfungsfläche der Kathode (8, 8') mittels des Führungskanals (20, 20') in einem Abstand zum Beschichtungsraum (4') angeordnet ist und dass die dem Beschichtungsraum (4') zugewandte Oeffnungsberandung des Führungskanals (20, 20') eine ringförmige Sichtblende zwischen der Kathode (8, 8') und den Halterungen (4) bildet, wobei die Halterungen peripher und jeweils im gleichen Abstand zur Achse (A) des Beschichtungsraumes (4') angeordnet sind, und dass die Ablenkmittel eine Magnetanordnung (22, 22', 23, 23', 24, 24') umfassen, die ein Magnetfeld (B, B') erzeugt, das im wesentlichen von der Kathode (8, 8') durch den Führungskanal (20, 20') gegen die Halterungen (4) gerichtet ist.

2. Anlage nach Anspruch 1, dadurch gekennzeichnet, dass im Bereich der Oeffnungsberandung des Führungskanals (20, 20') eine Ringanode (12, 12') vorgesehen ist.

3. Anlage nach einem der Ansprüche 1 oder 2, dadurch gekennzeichnet, dass die Oeffnungsberandung einen nach aussen ragenden Kragen (21, 21') aufweist.

4. Anlage nach einem der Ansprüche 1 bis 3, dadurch gekennzeichnet, dass, von der Kathode her betrachtet, oberhalb der Oeffnungsberandung eine Ringanode (12, 12') angeordnet ist, deren Oeffnung vorzugsweise einen grösseren Durchmesser aufweist als die Oeffnungsberandung.

5. Anlage nach einem der Ansprüche 1 bis 4, dadurch gekennzeichnet, dass, auf Abstand über der Kathode, mindestens zwei ringförmige, im Betrieb auf allenfalls unterschiedlichen anodischen Potentialen liegende Ringelektroden (12, 12', 21, 21') vorgesehen sind.

6. Anlage nach einem der Ansprüche 1 bis 5, dadurch gekennzeichnet, dass eine Glühkathode (26) für eine Niedervolt-Bogenentladung vorgesehen ist, vorzugsweise im Bereich der Kathode (8).

7. Anlage nach einem der Ansprüche 1 bis 6, dadurch gekennzeichnet, dass sie bezüglich einer Ebene (E) senkrecht zur Achse (A), spiegelbildlich, doppelt ausgebildet ist.

8. Anlage nach einem der Ansprüche 1 bis 7, dadurch gekennzeichnet, dass sie um die Achse (A) im wesentlichen rotationssymmetrisch aufgebaut ist.

9. Anlage nach einem der Ansprüche 1 bis 8, dadurch gekennzeichnet, dass, bezüglich der Halterungsanordnung (4) radial aussenliegend, ein anodisch betriebener Mantel (5b) vorgesehen ist.

10. Anlage nach einem der Ansprüche 1 bis 9, dadurch gekennzeichnet, dass das Magnetfeld der Magnetanordnung (22, 22', 23, 23', 24, 24') bezüglich einer Ebene (E) senkrecht zur Achse (A) spiegelbildlich verläuft.

11. Anlage nach einem der Ansprüche 1 bis 10, dadurch gekennzeichnet, dass die Magnetanordnung ansteuerbar ist zur Modulation des Magnetfeldes.

12. Anlage nach den Ansprüchen 10 und 11, dadurch gekennzeichnet, dass die Magnetanordnung zur unabhängigen Modulation der zueinander spiegelbildlichen Magnetfeldanteile (B, B') ausgebildet ist.

13. Anlage nach einem der Ansprüche 1 bis 12, dadurch gekennzeichnet, dass die Magnetanordnung mindestens eine Spulenanordnung (22, 22', 23, 23', 24, 24') umfasst.

## Claims

1. A vacuum coating installation for coating workpieces comprising at least one evaporation cathode (8, 8') disposed in a chamber (1) where vacuum may be created, the chamber (1) containing a coating space (4') provided with a ring-shaped wall (5a), at least one anode (12, 12'), supports (4) radially disposed in the coating space (4') for the workpieces, which are bereft from direct sight relation with the cathode (8, 8'), and deflector means (5b, 12, 12', 22, 22', 23, 23', 24, 24', 20, 20') for deflecting radially outwardly in all directions ions evaporated from the cathode (8, 8'), characterized in that
- the cathode (8, 8'),
- a cylindrical guiding channel (20, 20') for the particles evaporated from the cathode (8, 8') which, in operation of the installation, is set to a positive potential with respect to the cathode (8, 8'), and
- the coating space (4')
are arranged stepwise one behind another and coaxially along an axis (A), which crosses the cathode (8, 8') preferably at right angles so that the evaporation surface of the cathode (8, 8') is by means of the guiding channel (20, 20') located at a distance from the coating space (4') and the opening edge of the guiding channel (20, 20') facing towards the coating space (4') forms a ring-shaped screen between the cathode (8, 8') and the supports (4), with said supports being disposed peripherally and equidistantly from the axis (A) of the coating space (4'), and in that the deflector means comprises a magnet arrangement (22, 22', 23, 23', 24, 24') generating a magnetic field (B, B'), which is directed substantially from the cathode (8, 8') through the guiding channel (20, 20') towards the supports (4).

2. The installation according to claim 1, characterized in that in the region of the opening edge of the guiding channel (20, 20') there is provided a ring-shaped anode (12, 12').

3. The installation according to claim 1 or 2, characterized in that the opening edge comprises a flange (21, 21') projecting outwardly.

4. The installation according to any of claims 1 to 3, characterized in that, as seen from the cathode, above the opening edge, there is provided a ring-shaped anode (12, 12'), the opening of which is preferably larger in diameter than the opening edge.

5. The installation according to any of claims 1 to 4, characterized in that, at a distance above the cathode, there are provided at least two ring-shaped electrodes (12, 12', 21, 21'), which, in operation, are set to different anodic potentials, if necessary.

6. The installation according to any of claims 1 to 5, characterized in that there is provided a glow cathode (26) for a low voltage arc discharge, preferably in the region of the cathode (8).

7. The installation according to any of claims 1 to 6, characterized in that it is provided in dual form and symmetrically with respect to a plane (E) perpendicular to the axis (A).

8. The installation according to any of claims 1 to 7, characterized in that it is constructed so as to be substantially rotatably symmetrical about the axis (A).

9. The installation according to any of claims 1 to 8, characterized in that there is provided a jacket (5b) acting as an anode which extends radially outwardly with respect to the support arrangement (4).

10. The installation according to any of claims 1 to 9, characterized in that the magnetic field of the magnet arrangement (22, 22', 23, 23', 24, 24') is symmetrical with respect to a plane (E) perpendicular to the axis (A).

11. The installation according to any of claims 1 to 10, characterized in that the magnet arrangement is controllable for modulating the magnetic field.

12. The installation according to claims 10 and 11, characterized in that the magnet arrangement is provided for modulating separately the magnetic field parts (B, B'), which are symmetrical to each other.

13. The installation according to any of claims 1 to 12, characterized in that the magnet arrangement comprises at least one coil arrangement (22, 22', 23, 23', 24, 24').

## Revendications

1. Installation de revêtement sous vide pour le revêtement de pièces à usiner, comportant au moins une cathode d'évaporation (8, 8') disposée dans une chambre (1) dans laquelle on peut faire le vide, étant précisé que la chambre (1) comprend un espace de revêtement (4') pourvu d'une paroi annulaire (5a), au moins une anode (12, 12'), des supports (4), disposés radialement dans l'espace de revêtement (4'), pour les pièces, lesquelles sont privées d'un contact visuel direct avec la cathode (8, 8'), et des moyens de déviation (5b, 12, 12', 22, 22', 23, 23', 24, 24', 20, 20') pour dévier radialement vers l'extérieur, de tous les côtés, les ions évaporés à partir de la cathode (8, 8'), caractérisée en ce que
- la cathode (8, 8'),
- un canal de guidage cylindrique (20, 20') prévu pour les particules à évaporer à partir de la cathode (8, 8') et mis à un potentiel positif par rapport à la cathode (8, 8') lors du fonctionnement de l'installation, et
- l'espace de revêtement (4')
sont disposés de façon échelonnée les uns derrière les autres et coaxialement le long d'un axe (A) traversant de préférence perpendiculairement la cathode (8, 8'), de telle sorte que la surface d'évaporation de la cathode (8, 8') soit disposée grâce au canal de guidage (20, 20') à une certaine distance de l'espace de revêtement (4') et que le bord d'ouverture du canal de guidage (20, 20') tourné vers l'espace de revêtement (4') forme un cache annulaire entre la cathode (8, 8') et les supports (4), lesdits supports étant disposés à la périphérie et à égale distance de l'axe (A) de l'espace de revêtement (4'), et en ce que les moyens de déviation comprennent un dispositif d'aimants (22, 22', 23, 23', 24, 24') qui génère un champ magnétique (B, B') allant sensiblement de la cathode (8, 8') vers les supports (4) en passant par le canal de guidage (20, 20').

2. Installation selon la revendication 1, caractérisée en ce qu'il est prévu, dans la zone du bord d'ouverture du canal de guidage (20, 20'), une anode annulaire (12, 12').

3. Installation selon l'une des revendications 1 ou 2, caractérisée en ce que le bord d'ouverture comporte une collerette (21, 21') faisant saillie vers l'extérieur.

4. Installation selon l'une des revendications 1 à 3, caractérisée en ce qu'il est prévu, au-dessus du bord d'ouverture, vu à partir de la cathode, une anode annulaire (12, 12') dont l'ouverture présente de préférence un diamètre supérieur à celui du bord d'ouverture.

5. Installation selon l'une des revendications 1 à 4, caractérisée en ce qu'il est prévu, à une certaine distance au-dessus de la cathode, au moins deux électrodes annulaires (12, 12', 21, 21') qui, lors du fonctionnement, sont mises à des potentiels anodiques éventuellement différents.

6. Installation selon l'une des revendications 1 à 5, caractérisée en ce qu'il est prévu une cathode chaude (26) pour une décharge en arc à basse tension, de préférence dans la zone de la cathode (8).

7. Installation selon l'une des revendications 1 à 6, caractérisée en ce qu'elle est conçue en double et symétriquement par rapport à un plan (E) perpendiculaire à l'axe (A).

8. Installation selon l'une des revendications 1 à 7, caractérisée en ce qu'elle est construite sensiblement symétrique en rotation autour de l'axe (A).

9. Installation selon l'une des revendications 1 à 8, caractérisée en ce qu'il est prévu une enveloppe (5b) fonctionnant comme une anode, placée radialement à l'extérieur par rapport au dispositif de support (4).

10. Installation selon l'une des revendications 1 à 9, caractérisée en ce que le champ magnétique du dispositif d'aimants (22, 22', 23, 23', 24, 24') est symétrique par rapport à un plan (E) perpendiculaire à l'axe (A).

11. Installation selon l'une des revendications 1 à 10, caractérisée en ce que le dispositif d'aimants est apte à être commandé en vue de la modulation du champ magnétique.

12. Installation selon les revendications 10 et 11, caractérisée en ce que le dispositif d'aimants est conçu pour la modulation indépendante des parties de champ magnétique (B, B') symétriques l'une par rapport à l'autre.

13. Installation selon l'une des revendications 1 à 12, caractérisée en ce que le dispositif d'aimants comprend au moins un dispositif de bobines (22, 22', 23, 23', 24, 24').
